Europäisches Patentamt

(19) European Patent Office

Office européen des brevets

(11) **EP 0 776 046 A1**

(12) **EUROPEAN PATENT APPLICATION**

(43) Date of publication:
28.05.1997 Bulletin 1997/22

(51) Int. Cl.$^6$: **H01L 27/12**, G06F 7/50

(21) Application number: **96118642.6**

(22) Date of filing: **20.11.1996**

(84) Designated Contracting States:
**DE FR GB**

(30) Priority: **24.11.1995 JP 329965/95**

(71) Applicant: **NEC CORPORATION**
**Tokyo (JP)**

(72) Inventor: **Kumagai, Kouichi**
**Minato-ku, Tokyo (JP)**

(74) Representative: **Glawe, Delfs, Moll & Partner**
**Patentanwälte**
**Postfach 26 01 62**
**80058 München (DE)**

(54) **SOI CMOS logic circuit with transfer gates**

(57) Pass transistor logic circuits are formed on an SOI (Silicon On Insulator) substrate, which can significantly reduce the capacitances of the source/drain diffusion layers of MOS transistors, by using CMOS transfer gates (TG0~TG13). The pass transistor logic circuits are connected in multistage and in series in a signal propagation direction to form a logic, thereby improving the operational speed and reducing the number of transistors and power dissipation.

FIG. 17

EP 0 776 046 A1

## Description

The present invention relates to a semiconductor integrated circuit, and, more particularly, to a CMOS logic circuit with an SOI (Silicon On Insulator) substrate.

The recent CMOS logic LSI has partially employed a pass transistor logic circuit in order to speed up the circuit operation and reduce the layout area. This pass transistor circuit structure is particularly effective in constructing an exclusive OR (EX-OR) gate, an exclusive NOR (EX-NOR) gate, a selector and the like whose construction is difficult (which increases the number of required transistors) by using ordinary CMOS gate circuits.

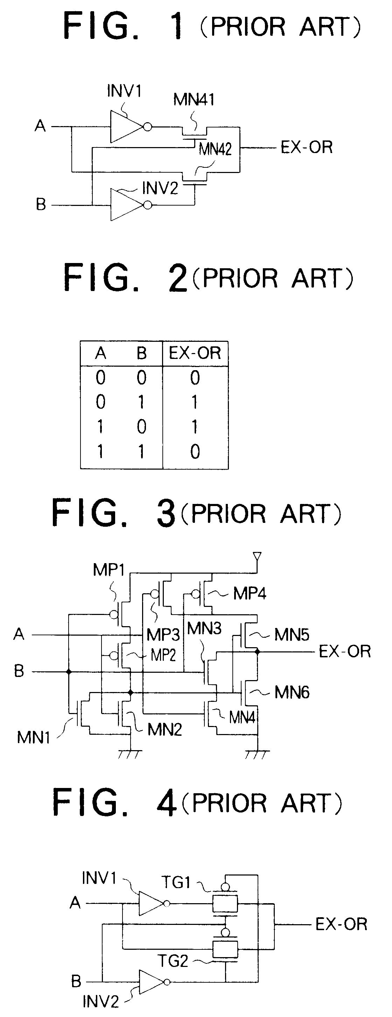

Fig. 1 is a circuit diagram of an EX-OR gate constituted by using pass transistors each comprised of an N channel MOS transistor, and Fig. 2 is a truth table in that case. Referring to Fig. 1, the EX-OR gate comprises a first inverter INV1 which receives an input A, a first pass transistor MN41 connected between the output of the first inverter INV1 and an output terminal, a second inverter INV2 which receives an input B, and a second pass transistor MN42 connected between the input A and the output terminal. The input B is connected to the gate of the first pass transistor MN41, and the output of the second inverter INV2 is connected to the gate of the second pass transistor MN42. When the input B has a high level (= "1"), the first pass transistor MN41 is enabled and the second pass transistor MN42 is disabled, so that an inverted signal of the input A obtained by the first inverter INV1 appears at the output terminal. When the input B has a low level (= "0"), the second pass transistor MN42 is enabled and the first pass transistor MN41 is disabled, so that the potential of the input A is output on the output terminal via the second pass transistor MN42.

Fig. 3 is a circuit diagram of an EX-OR gate constituted by ordinary CMOS gate circuits. Referring to Fig. 3, the EX-OR gate comprises N channel MOS transistors MN1 and MN2, which have sources grounded, gates respectively supplied with inputs B and A and drains connected together, P channel MOS transistors MP1 and MP2, which have gates respectively supplied with the inputs B and A and are connected in series between a voltage supply and the node of the drains of the MOS transistors MN1 and MN2, N channel MOS transistors MN3 and MN4, which have gates respectively supplied with the inputs B and A with the source of the MOS transistor MN3 connected to the drain of the transistor MN4, an N channel MOS transistor MN6, which has a gate connected to the node of the drains of the MOS transistors MN1 and MN2, a drain connected to the drain of the MOS transistor MN3, and a source grounded together with the source of the MOS transistor MN4, and P channel MOS transistors MP3 and MP4, which have gates respectively supplied with the inputs A and B and are connected in parallel between the voltage supply and the drain of a P channel MOS transistor MN5.

Six transistors are used in the circuit in Fig. 1 which uses pass transistors constituted of N channel MOS transistors, whereas ten transistors (six N channel MOS transistors and four P channel MOS transistors) are used in the circuit in Fig. 3 which is constituted of ordinary CMOS gate circuits.

In a specific circuit, as apparent from the above, a pass transistor circuit requires fewer transistors than a CMOS gate circuit, and is therefore advantageous in reducing the layout area on a semiconductor (silicon) substrate.

In the N channel pass transistor circuit in Fig. 1, however, the high-level potential of the output node (EX-OR) becomes equal to or lower than a supply voltage $V_{DD}$ - Vtn (where Vtn is the gate threshold voltage of an N channel MOS transistor). When this potential is input to the subsequent stage, the leak current of a gate at this subsequent stage increases, resulting in increased power dissipation.

In addition, such N channel MOS transistors are connected in a multistage form and in series in the signal propagation direction, the high level of the output becomes lower than that in the case of a single stage of an N channel MOS transistor due to the back bias effect of the substrate. This further increases the power dissipation at the gate at the subsequent stage. In this respect, the series connection of N channel MOS transistors in a multistage form is not recommendable.

To overcome the problem that the high-level potential of the output of the above-described pass transistor circuit constituted of N channel MOS transistors does not rise up to the level of the supply voltage, a pass transistor circuit using a CMOS transfer gate has been put to a practical use.

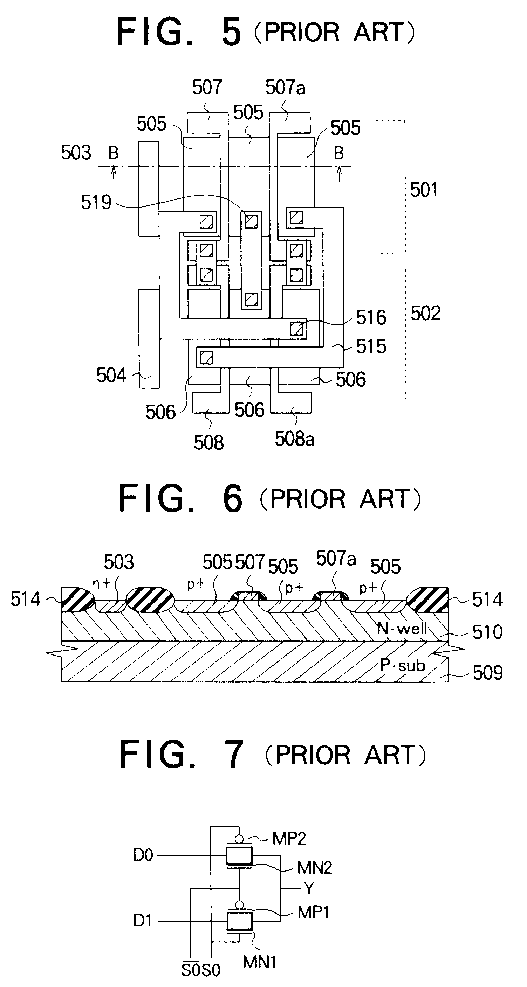

Fig. 4 is a circuit diagram of an EX-OR gate constituted of a CMOS transfer gate. Fig. 5 is a layout diagram of a 2-1 selector constituted of a CMOS transfer gate, Fig. 6 is a cross-sectional view along the line B-B in Fig. 5, and Fig. 7 is a circuit diagram of the 2-1 selector.

As shown in Figs. 4 and 7, this CMOS transfer gate has the sources of a P channel MOS transistor and an N channel MOS transistor connected together and the drains of both MOS transistors connected together, and serves to switch between the ON (conducting state) state and the OFF state (high-impedance state) of signal propagation between the sources and drains of the thus connected P channel and N channel MOS transistors by the application of complementary signals to the gates of both MOS transistors.

Referring to Fig. 7, when a select line S0 is at a high level, a select line $\overline{S0}$ which is complementary to the select line S0 is set to a low level, an N channel MOS transistor MN1 and a P channel MOS transistor MP1 are enabled, and an N channel MOS transistor MN2 and a P channel MOS transistor MP2 are disabled. Consequently, an input D1 appears on an output Y. When the select line S0 is at a low level, the complementary select line $\overline{S0}$ is set to a high level, the N channel MOS transistor MN2 and the P channel MOS transistor MP2 are enabled. As a result, an input D0

2

appears on the output Y.

In the layout diagram in Fig. 5, reference numeral "501" denotes the P channel MOS transistors MP1 and MP2, and reference numeral "502" denotes the N channel MOS transistors MN1 and MN2 (see Fig. 7). A line 515 is a line (input D1) to connect the source of the P channel MOS transistor MP1 to the drain of the N channel MOS transistor MN1, and a line 516 is a line (input D0) to connect the source of the P channel MOS transistor MP2 to the drain of the N channel MOS transistor MN2. Reference numeral "505" indicates a P type diffusion layer of the P channel MOS transistors MP1 and MP2, and reference numeral "506" an N type diffusion layer of the N channel MOS transistors MN1 and MN2. The P type diffusion layer 505 (the drains of the P channel MOS transistors MP1 and MP2) and the N type diffusion layer 506 (the sources of the N channel MOS transistors MN1 and MN2) are connected together via a contact (see a line 519) as an output Y. Lines 507 and 508, which are connected together via a contact, are associated with the select line S0 which is connected to the gates of the P channel MOS transistor MP2 and the N channel MOS transistor MN1. Lines 507a and 508a, which are connected together via a contact, are associated with the select line $\overline{S0}$ which is connected to the gates of the P channel MOS transistor MP1 and the N channel MOS transistor MN2.

Eight transistors are used in the EX-OR gate in Fig. 4, and four transistors are used in the 2-1 selector in Fig. 7, 4. Those circuit functions can be accomplished by fewer transistors than the same circuit functions which are accomplished by the use of a CMOS gate and which respectively require ten transistors (see Fig. 3) and twelve transistors.

It is apparent that the a pass transistor circuit constituted of a CMOS transfer gate can contribute to reducing the number of required transistors in a specific circuit as compared with the CMOS gate structure.

In the pass transistor circuit constituted of a CMOS transfer gate, however, the capacitance of the source and drain diffusion layer of the CMOS transfer gate is increased by the added P channel MOS transistor. This pass transistor circuit therefore suffers a lower operational speed than a pass transistor circuit using N channel MOS transistors.

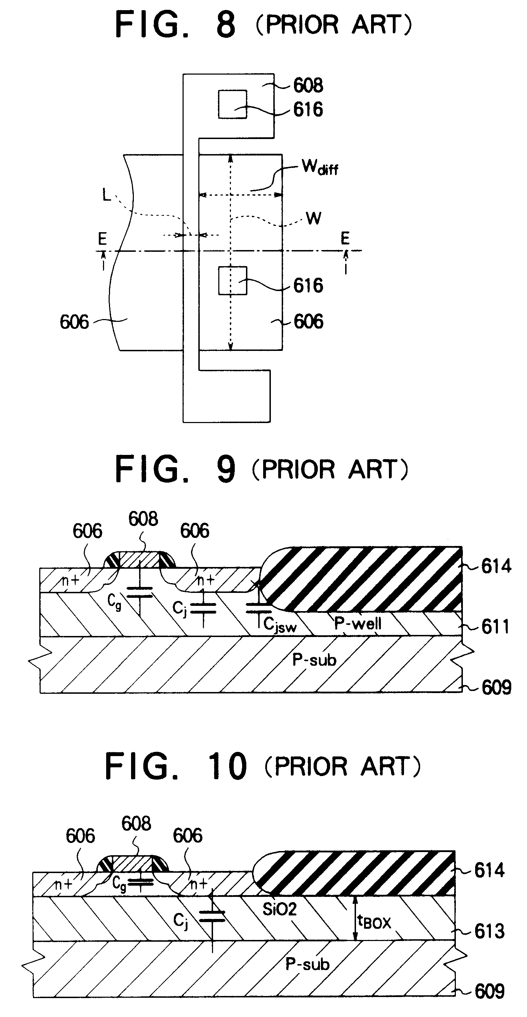

Referring now to Figs. 8 and 9 illustrating the layout of transistors with a gate width W ($\mu$m), the gate capacitance and the capacitance of the N type diffusion layer in a balk CMOS having a gate length (L) of 0.5 $\mu$m will be calculated.

The gate capacitance Cg is a capacitance between the gate and P well via a gate oxide film. Given that the thickness of the gate oxide film (tox) is 11 nm, Cg is given by

$$Cg = \varepsilon \times (W \times Wdiff)/tox \qquad \qquad (1)$$
$$= 1.57 \times W \text{ (fF)}$$

where $\varepsilon$ is an SiO$_2$ dielectric constant and $\varepsilon$ = 3.45E - 13 (= $3.45 \times 10^{-13}$) F/cm.

The capacitance of the N type diffusion layer (Cdiff) for a balk is a PN junction capacitance between the source and drain diffusion layer and the P well.

Given that the bottom component (Cjn) of the capacitance of the N type diffusion layer is $5 \times 10^{-4}$ (F/m$^2$), the peripheral length component (Cjswn) of the capacitance of the N type diffusion layer is $2.5 \times 10^{-10}$ (F/m$^2$), and the width Wdiff ($\mu$m) of the diffusion layer where a contact having a contact size (CT) of $0.6 \times 0.6$ $\mu$m can be arranged is Wdiff = 3 $\times$ CT, Cdiff is given by

$$Cdiff = Wdiff \times W \times Cjn + 2 \times (Wdiff + W) \times Cjswn \qquad \qquad (2)$$
$$= 0.9 + 1.4 \times W \text{ (fF)}$$

With the gate width (W) being 10 $\mu$m, Cg and Cdiff in equations (1) and (2) become

$$Cg = 15.7 \text{ (fF)}$$

$$Cdiff = 14.9 \text{ (fF)}$$

which are nearly equal to each other.

Since the pass transistor circuit constituted of a CMOS transfer gate suffers a delay equivalent to one gate stage, therefore, even if pass transistor circuits each constituted of the CMOS transfer gate are connected in multistage and in series in the signal propagation direction, an improvement on the operational speed is not expected. To compensate for the operational speed, the insertion of a buffer or some other measures have actually, been taken so that there hardly is an advantage of connecting pass transistor circuits using CMOS transfer gates in series in a multistage form.

In the conventional pass transistor circuit constituted of N channel MOS transistors, as mentioned above, the high-level potential of its output becomes an intermediate potential equal to or lower than the supply voltage $V_{DD}$ -Vtn, and when this potential is input to the subsequent stage, the leak current of the gate at the subsequent stage increases, resulting in increased power dissipation. Further, the connection of N channel MOS transistors in a multistage form in series in the signal propagation direction makes the output potential become lower than that in the case of a single stage of an N channel MOS transistor due to the back bias effect of the substrate. This further increases the power dissipation at the gate at the subsequent stage.

With regard to the pass transistor circuit constituted of a CMOS transfer gate, the capacitance of the source and drain diffusion layer is doubled the capacitance in the case where a pass transistor circuit is constituted of N channel MOS transistors. As apparent from the above-given calculation, because the gate capacitance and the capacitance of the source and drain diffusion layer are nearly equal to each other for ordinary balk CMOS, the pass transistor circuit constituted of a CMOS transfer gate suffers a delay equivalent to one gate stage. Therefore, even if pass transistor circuits each constituted of a CMOS transfer gate are connected in multistage and in series in the signal propagation direction, an improvement on the operational speed is not expected.

Accordingly, it is an object of the present invention to provide a semiconductor integrated circuit capable of increasing the operational speed of a CMOS logic circuit and reducing the power dissipation and the number of required elements.

To achieve the above object, according to one aspect of this invention, a CMOS logic circuit with an SOI (Silicon On Insulator) substrate has a plurality of stages of CMOS transfer gates connected in series in a signal propagation direction, each CMOS transfer gate having P channel MOS transistors and N channel MOS transistors formed on the SOI substrate, sources of an associated one of the P channel MOS transistors and an associated one of the N channel MOS transistors being connected to each other and drains of the associated P channel MOS transistor and the associated N channel MOS transistor being connected to each other for respectively supplying complementary signals to gates of the associated P channel MOS transistor and the associated N channel MOS transistor to switch between enableness and disableness of signal propagation between the sources and the drains of the associated P channel MOS transistor and the associated N channel MOS transistor.

In this CMOS logic circuit with an SOI substrate, it is preferable that the CMOS transfer gates connected in series in the signal propagation direction should be used for a carry signal generator of an adder.

According to this invention, a pass transistor logic circuit constituted of a CMOS transfer gate is formed on the SOI substrate, which can significantly reduce the capacitances of the source/drain diffusion layers of MOS transistors, and this structure can reduce the power dissipation and improve the operational speed of the circuit.

In the drawings:

Fig. 1 is a circuit diagram showing a pass transistor structure using N channel MOS transistors;
Fig. 2 is a diagram showing a truth table for an exclusive OR;
Fig. 3 is a circuit diagram depicting a CMOS gate structure;
Fig. 4 is a circuit diagram showing a pass transistor structure using a CMOS transfer gate;
Fig. 5 is a layout diagram of a 2-1 selector having a pass transistor structure using a CMOS transfer gate;
Fig. 6 is a cross-sectional view of a PMOS section taken along the line B-B in Fig. 5;
Fig. 7 is a circuit diagram of a 2-1 selector using a CMOS transfer gate;
Figs. 8 through 10 are diagrams used for explaining the capacitance of the source and drain diffusion layer of an MOS transistor, in which Fig. 8 is a layout diagram, Fig. 9 is a cross-sectional view when CMOS is formed on a silicon balk substrate, and Fig. 10 is a cross-sectional view when CMOS is formed on an SOI substrate; and
Fig. 11 is a circuit diagram of an 8-1 selector having a conventional CMOS gate structure.
Fig. 12 is a layout diagram of a 2-1 selector which has a pass transistor structure using a CMOS transfer gate according to the first embodiment of this invention;
Fig. 13 is a circuit diagram of the 2-1 selector in Fig. 12;
Fig. 14 is circuit diagram of a 2-1 selector having a CMOS gate structure;
Fig. 15 is a diagram showing a truth table for the 2-1 selector;
Fig. 16 is a partly cross-sectional view of PMOS;
Fig. 17 is a diagram showing the structure of an 8-1 selector according to the second embodiment of this invention;
Fig. 18 is a diagram showing a truth table for the 8-1 selector;
Fig. 19 is a circuit diagram illustrating the general structure of a 4-bit carry lookahead circuit according to the third embodiment of this invention;
Fig. 20 is a circuit diagram of a carry signal generator to which this invention is adapted;

Preferred embodiments of the present invention will now be described with reference to the accompanying drawings.

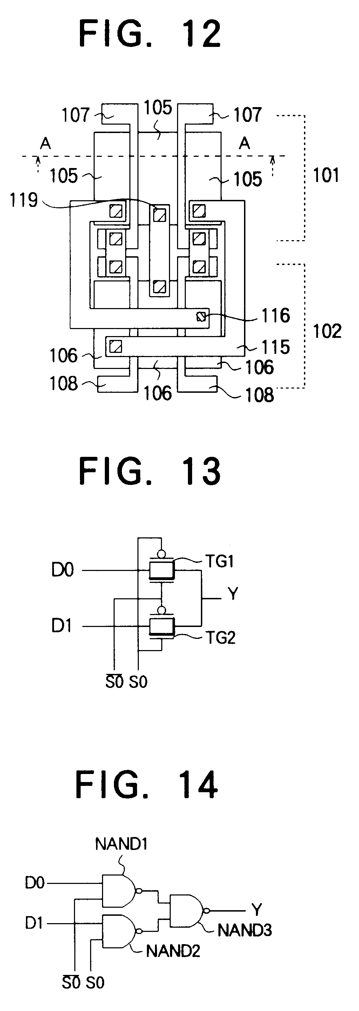

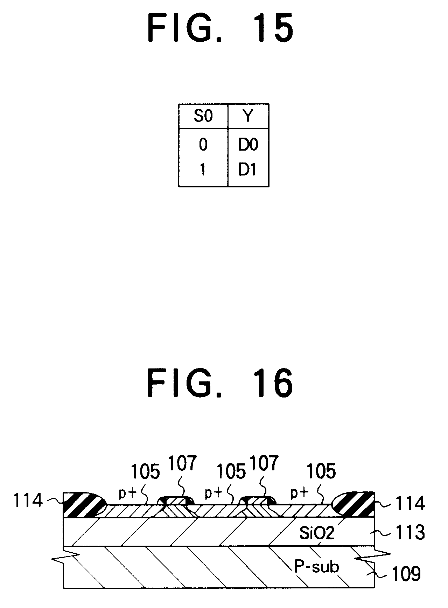

Figs. 12 through 16 are diagrams for explaining the first embodiment of this invention. Fig. 12 is a layout diagram of a pass transistor circuit in which a 2-1 selector is formed on an SOI substrate using a CMOS transfer gate, Fig. 13 is a circuit diagram, and Fig. 16 is a partly cross-sectional view of a P channel MOS transistor array section (along the line A-A in Fig. 12). Fig. 14 shows the circuit structure of a 2-1 selector which comprises NAND gates constituted of CMOS transfer gates, and Fig. 15 shows a truth table for the 2-1 selector. Referring to Fig. 12, an output node Y is where the source diffusion layers of two N channel MOS transistors are connected and the drain diffusion layers of two P channel MOS transistors are connected. As shown in Fig. 13, the 2-1 selector has CMOS transfer gates TG1 and TG2 which have one ends respectively connected to inputs D0 and D1 and the other ends commonly connected to the output Y.

Each CMOS transfer gate TG1 or TG2 is constituted of an N channel MOS transistor and a P channel MOS transistor whose gates are supplied with complementary signals. As has been explained with reference to Fig. 7, in accordance with the high/low level of a select signal S0, the CMOS transfer gates TG2 and TG1 are enabled and the input D1 or D0 is selectively output from the output Y. In Fig.12, "105" is the P type diffusion layer of the P channel MOS transistor in each of the CMOS transfer gates TG1 and TG2, and "106" is the N type diffusion layer of the N channel MOS transistor in each CMOS transfer gate TG1 or TG2. The P type diffusion layer 105 and the N type diffusion layer 106 are connected (see a line 109) via a contact to be the output Y. Lines 115 and 116 are respectively associated with the inputs D1 and D0, lines 107 and 108 on the left-hand side in the diagram are associated with a select line (gate line) S0 and lines 107 and 108 on the right-hand side in the diagram are associated with a select line (gate line) $\overline{S0}$.

For an MOS transistor formed on an SIMOX (Separation by IM plantation OXygen) substrate which is a typical SOI substrate, as shown in Fig. 16, the bottom of the source and drain diffusion layer 105 is in contact with a buried oxide film 113 so that the capacitance of the source and drain diffusion layer essentially becomes the capacitance between of the source and drain diffusion layer 105 and a silicon substrate 109 via the buried oxide film 113. Given that the thickness of the buried oxide film (tBOX) 613 is 100 nm, and the width Wdiff ($\mu$m) of the diffusion layer where a contact having a contact size (CT) of $0.6 \times 0.6$ $\mu$m can be arranged is Wdiff = $3 \times$ CT, the diffusion layer capacitance Csoi is calculated from the following equation (3) in the same way as the gate capacitance (Cg):

$$Csoi = \varepsilon \times (W \times Wdiff)/tBox \qquad\qquad (3)$$
$$= 0.28 \times W \text{ (fF)}$$

where $\varepsilon$ is an $SiO_2$ dielectric constant and $\varepsilon = 3.45 \times 10^{-13}$

F/cm. With the gate width W = 10 $\mu$m, from equations (2) and (3), the diffusion layer capacitance Cdiff for the balk and the diffusion layer capacitance Csoi for SOI become

$$Cdiff = 14.9 \text{ (fF)}$$

$$Csoi = 2.8 \text{ (fF)}.$$

The diffusion layer capacitance for SOI (Csoi) is approximately 19% of that for the balk (Cdiff).

When a pass transistor circuit constituted of a CMOS transfer gate is formed on the SOI substrate, therefore, the connection of pass transistors each constituted of a CMOS transfer gate in multistage and in series in the signal propagation direction can reduce the number of required transistors and the power dissipation without degrading the operational speed.

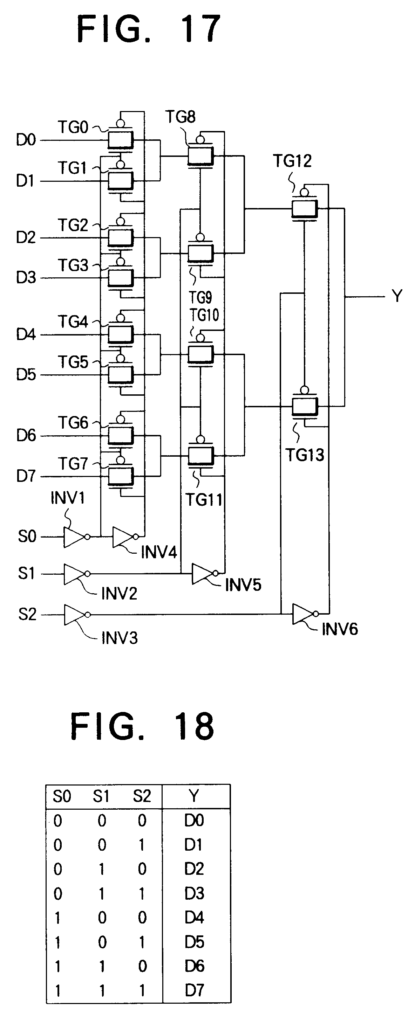

Fig. 17 is a circuit diagram illustrating the second embodiment of this invention in which the 2-1 selectors on the SOI substrate shown in Fig. 12 are combined to form an 8-1 selector. Fig. 18 is a truth table for the 8-1 selector. This 8-1 selector is capable of allowing one of eight input data signals (D0 to D7) to be selected by a 3-bit select signal (S0-S2) and be propagated to the output terminal (Y).

While an input data signal (D0-D7) passes three transfer gates before reaching the output terminal (Y) in the circuit shown in Fig. 17 (e.g., when D0 is selected due to S0 = S1 = S2 = low level , D0 passes three transfer gates TG0, TG8 and TG12), there are eight charging/discharging diffusion layers which lie between the input terminal (D0-D7) and the output terminal (Y) for each type of MOS transistors, P channel or N channel MOS transistors.

Since the diffusion layer capacitance for SOI (Csoi) is approximately 19% of that for the balk (Cdiff) as has already been considered, the diffusion layer load capacitance from the input terminal (D0-D7) to the output terminal (Y) is equivalent to about 1.5 stages of balk CMOS inverters.

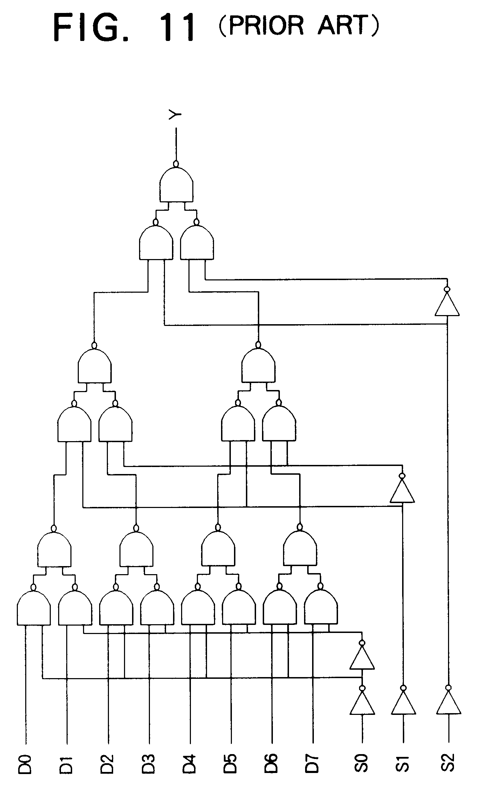

Fig. 11 presents a circuit diagram in the case where an 8-1 selector which has the same logic as expressed by the truth table in Fig. 18 is constituted without using transfer gates.

In the 8-1 selector shown in Fig. 11, as an input data signal passes six gates while traveling from the input terminal (D0-D7) to the output terminal (Y), the diffusion layer capacitance on the same path in the structure using a balk substrate in Fig. 11 is greater by more than four times that in the structure of the circuit in Fig. 17.

With regard to the number of required transistors, the circuit in Fig. 17 requires 40 transistors whereas the circuit in Fig. 11 requires 96 transistors. It is apparent that this embodiment can considerably reduce the number of required transistors.

As apparent from the above, it is possible to reduce the number of transistors and the dissipation power without degrading the operational speed in this embodiment too.

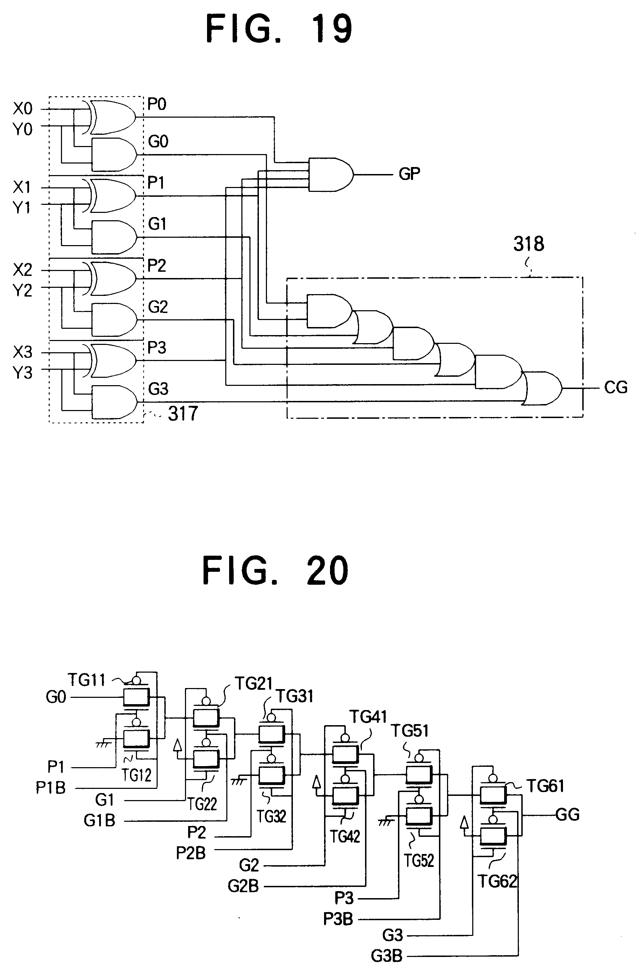

Fig. 19 illustrates a part of the circuit structure of an adder as the third embodiment of this invention, and the structure of a 4-bit carry lookahead circuit.

With regard to arithmetic operations of binary numbers, subtraction is performed by adding a 2's complement to a minuend so that an adder is a basic circuit in the four arithmetic operations. The path of a carry signal (carry path) is the critical path that determines the computation speed.

In an RCA (Ripple Carry Adder) which generates a carry signal for each bit and permits the carry signal to be propagated to a full adder for the next upper bit, an addition delay becomes larger in proportion to the number of bits.

The carry lookahead circuit in Fig. 19 previously computes a carry signal (GG) for four bits as one group and allows this carry signal (GG) to be propagated to a group of next upper four bits to thereby improve the computation speed of the adder. It is to be noted that individual signals Xi and Yi (i = 0 to 3) are input to an associated half adder, which comprises an exclusive OR (EX-OR) gate and an AND gate, an output Pi (= Xi + Yi; propagate signal) is output from the EX-OR gate, an output Gi (= Xi • Yi; generate signal) is output from the AND gate, and GP and GG are produced from those outputs Pi and Gi. A circuit block (carry signal generator) 318 generates the carry signal GG through a logic operation GG = G3+P3 • (G2+P2 • (G1+P1 • G0)) .

The signal GP is produced by GP = P0 • P1 • P2 • P3 .

The carry lookahead circuit according to this embodiment of the invention accomplishes the logic of the combination of the AND gates and OR gates in the block 318 in Fig. 19 by the pass transistor circuit comprised of CMOS transfer gates as shown in Fig. 20. P1B to P3B, and G1B to G3B are complementary signals of P1 to P3 and G1 to G3. The carry signal generator comprises two transfer gates TG11 and TG12 for selecting either the ground level (low level) or the signal G0 in response to the complementary signals P1 and P1B, two transfer gates TG21 and TG22 for selecting either the supply voltage potential (high level) or the potential at the node of the transfer gates TG11 and TG12 at the previous stage in response to the complementary signals G1 and G1B, and so forth up to two transfer gates TG61 and TG62 for selecting either the high level or the potential at the node of transfer gates TG51 and TG52 at the previous stage in response to the complementary signals G3 and G3B, and produces the output CG from the node of the two transfer gates TG61 and TG62. When the signal G3 has a high level, a high level output is propagated to CG from the transfer gate TG62, and when the signal G3 has a low level, the output signals of the transfer gates TG51 and TG52 are output to CG. Actually, the result of the logic operation CG3 = G3+P3 • (G2+P2 • (G1+P1 • G0)) is output.

In this case, the longest path of the circuit (critical path) runs along a series circuit of six stages of CMOS transfer gates from G0 to GG.

There are eighteen charging/discharging diffusion layers present from G0 to GG for each type of MOS transistors, P channel or N channel MOS transistors.

Since the diffusion layer capacitance for SOI (Csoi) is approximately 19% of that for the balk (Cdiff) as in the embodiment illustrated in Fig. 17, the diffusion layer load capacitance from G0 to GG is equivalent to about 3.5 stages of balk CMOS inverters.

When the same combination of the AND gates and OR gates in Fig. 19 is employed without using transfer gates, the number of stages of gates lying from G0 to GG is equivalent to 12 stages of CMOS inverters. Therefore, the diffusion layer capacitance on the critical path in the carry signal generator 318 in Fig. 19 is more than three times as great as that for the circuit in Fig. 20.

The circuit in this case, like the circuit in Fig. 17, can be constituted of fewer transistors, namely 24 transistors for the circuit in Fig. 20 whereas 36 transistors are needed for the CMOS gate structure as employed in the block 318 in Fig. 19.

According to this embodiment too, a carry lookahead circuit if designed to have the circuit structure shown in Fig. 20 can increase the propagation speed of the critical path of an adder using the carry lookahead circuit.

In short, according to this invention, pass transistor logic circuits are formed on an SOI substrate, which can significantly reduce the capacitances of the source/drain diffusion layers of MOS transistors, by using CMOS transfer gates, and are connected in multistage and in series in the signal propagation direction to form a logic. This improves the operational speed and reduces the number of transistors to be used and power dissipation.

## Claims

1. A CMOS logic circuit with an SOI (Silicon On Insulator) substrate characterized by comprising:

   a plurality of stages of CMOS transfer gates (TG0~TG13 ) connected in series in a signal propagation direction, each CMOS transfer gate having P channel MOS transistors (101) and N channel MOS transistors (102) formed on said SOI substrate, sources of an associated one of said P channel MOS transistors (101) and an associated one of said N channel MOS transistors (102) being connected to each other and drains of said associated P channel MOS transistor and said associated N channel MOS transistor being connected to each other for respectively supplying complementary signals to gates of said associated P channel MOS transistor and said associated N channel MOS transistor to switch between enableness and disableness of signal propagation between said sources and said drains of said associated P channel MOS transistor and said associated N channel MOS transistor.

2. The CMOS logic circuit with an SOI substrate according to claim 1, characterized in that
   said CMOS transfer gates (TG0~TG13) connected in series in said signal propagation direction is used for a carry signal generator of an adder.

3. A CMOS logic circuit with an SOI substrate characterized by comprising:

at least one CMOS transfer gate (TG0~TG13) inserted in series between an input signal terminal and an output signal terminal (Y), each CMOS transfer gate (TG0~TG13) having a P channel MOS transistor and an N channel MOS transistor formed on said SOI substrate, signal terminals of said P channel MOS transistor and said N channel MOS transistor being connected to each other and gates of said P channel MOS transistor and said N channel MOS transistor being input complementary signals.

4. The CMOS logic circuit with an SOI substrate according to claim 3, characterized in that said CMOS transfer gates (TG0~TG13) inserted in series between said input signal terminals and said output signal terminal (Y) constitutes a selector for selecting one of signals of said input signal terminals to output it to said output terminal based on said complementary signals.

5. The CMOS logic circuit with an SOI substrate according to claim 2, characterized in that a plurality of said CMOS transfer gates (TG0~TG13) are inserted in series in a carry signal path of said carry signal generator of said adder.

# FIG. 1 (PRIOR ART)

# FIG. 2 (PRIOR ART)

| A | B | EX-OR |
|---|---|-------|
| 0 | 0 | 0 |
| 0 | 1 | 1 |
| 1 | 0 | 1 |
| 1 | 1 | 0 |

# FIG. 3 (PRIOR ART)

# FIG. 4 (PRIOR ART)

# FIG. 5 (PRIOR ART)

507    507a
505
505    505
503  B                    B
519
501

516    502
515
504
506
506    506
508    508a

# FIG. 6 (PRIOR ART)

503        505 507 505   507a  505
514    n+      p+      p+      p+      514
N-well    510
P-sub    509

# FIG. 7 (PRIOR ART)

D0 ──── MP2
──── MN2
──── Y
D1 ──── MP1
──── MN1
$\overline{S0}$ S0

9

# FIG. 8 (PRIOR ART)

608
616

$W_{diff}$

L

W

E          E

606

616

606

# FIG. 9 (PRIOR ART)

606   608   606

n+        n+

$C_g$   $C_j$   $C_{jsw}$

P-well

614

611

P-sub

609

# FIG. 10 (PRIOR ART)

606   608   606

n+        n+

$C_g$

$C_j$

SiO2

$t_{BOX}$

614

613

P-sub

609

10

# FIG. 11 (PRIOR ART)

# FIG. 12

107 105 107

A A 101

105 105

119

116 102

115

106 106

108 106 108

# FIG. 13

D0 ──── TG1

Y

D1 ──── TG2

S̄0 S0

# FIG. 14

NAND1

D0 ───

Y

D1 ───

NAND3

NAND2

S̄0 S0

# FIG. 15

| S0 | Y |
|----|-----|
| 0  | D0  |
| 1  | D1  |

# FIG. 16

# FIG. 17

# FIG. 18

| S0 | S1 | S2 | Y |
|----|----|----|----|
| 0 | 0 | 0 | D0 |
| 0 | 0 | 1 | D1 |
| 0 | 1 | 0 | D2 |
| 0 | 1 | 1 | D3 |
| 1 | 0 | 0 | D4 |
| 1 | 0 | 1 | D5 |
| 1 | 1 | 0 | D6 |
| 1 | 1 | 1 | D7 |

# FIG. 19

# FIG. 20

EP 0 776 046 A1

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| Y | EP 0 543 361 A (CANON KK) 26 May 1993 * column 31, line 44 - column 32, line 46; figures 43-45 * | 1-5 | H01L27/12 G06F7/50 |
| Y | EP 0 347 029 A (FUJITSU LTD) 20 December 1989 * page 22, line 27 - page 23, line 13; figures 23,24 * | 1-5 | |
| P,X | EP 0 709 893 A (CANON KK) 1 May 1996 * page 7, line 15 - line 17 * * page 8, line 24 - line 56; figure 22 * | 3 | |
| A | US 5 055 842 A (MUELLER RUDI) 8 October 1991 * column 7, line 36 - line 53; figure 5 * | 1,3,4 | |
| A | IEEE INTERNATIONAL SOLID-STATE CIRCUITS CONFERENCE, no. 36, February 1993, NEW YORK, US, pages 90-91, XP000388034 M. SUZUKI ET AL.: "TA5.4:A 1.5ns 32b CMOS ALU in Double Pass-Transistor Logic" * page 90, column 1, line 42 - column 2, line 12; figure 3 * | 2,5 | TECHNICAL FIELDS SEARCHED (Int.Cl.6) H01L G06F |
| A | US 5 233 233 A (INOUE YOSHITSUGU ET AL) 3 August 1993 * abstract * | 4 | |

The present search report has been drawn up for all claims

| Place of search | Date of completion of the search | Examiner |
|---|---|---|
| THE HAGUE | 20 February 1997 | Albrecht, C |